Europäisches Patentamt

European Patent Office

Office européen des brevets

(19)

(11) Veröffentlichungsnummer: **0 219 711**

**A1**

(12) # EUROPÄISCHE PATENTANMELDUNG

(21) Anmeldenummer: 86113155.5

(51) Int. Cl.⁴: **G08B 29/00**

(22) Anmeldetag: 24.09.86

(30) Priorität: 08.10.85 DE 3535919

(43) Veröffentlichungstag der Anmeldung:
29.04.87 Patentblatt 87/18

(84) Benannte Vertragsstaaten:
CH DE FR GB IT LI NL SE

(71) Anmelder: Heimann GMBH
Weher Köppel 6
D-6200 Wiesbaden 1(DE)

(72) Erfinder: Schaaf, Norbert, Dipl.-Ing.
Heerstrasse 19A
D-6200 Wiesbaden(DE)

(74) Vertreter: Mehl, Ernst, Dipl.-Ing. et al
Postfach 22 01 76
D-8000 München 22(DE)

(54) **Infrarotdetektor.**

(57) Die Erfindung bezieht sich auf einen Infrarotdetektor mit mindestens einem infrarotempfindlichen Detektorelement (6). Im Gehäuse ist mindestens ein Infrarotsender (13) angeordnet, dessen Strahlung auf das Detektorelement (6) gerichtet ist und dem ein Pulsgenerator (20) für die Pulsung der Infrarotstrahlung zugeordnet ist. Dem Detektorelement (6) ist eine Erkennungsschaltung (21) für das vom Infrarotdetektor erzeugte Signal zugeordnet. Auf diese Weise kann die Funktionsfähigkeit des Detektorelementes (6) kontinuierlich überprüft werden. Bei mehreren Detektorelementen kann jedem Detektorelement je ein Infrarotsender zugeordnet sein. Als Infrarotsender kann ein beheizter hochohmiger Widerstand (13) oder eine Leuchtdiode Verwendung finden.

FIG 1

EP 0 219 711 A1

## Infrarotdetektor

Die Erfindung betrifft einen Infrarotdetektor mit mindestens einem infrarotempfindlichen Detektorelement, bei dem mindestens ein Infrarotsender vorhanden ist, dessen Strahlung auf das Detektorelement gerichtet ist und dem ein Pulsgenerator für die Pulsung der Infrarotstrahlung zugeordnet ist, und bei dem dem Detektorelement eine Erkennungsschaltung für das vom Infrarotsender erzeugte Signal zugeordnet ist.

Eine der Hauptforderungen, die an Alarmanlagen gestellt werden, in denen solche Infrarotdetektoren angewendet werden, ist neben der Fehlalarmsicherheit und einfachen Handhabung die Forderung nach weitgehender Selbstkontrolle der Anlage bzw. der einzelnen Funktionselemente. Bei aktiven Meldesystemen ist die Selbstkontrolle der Detektoren gegeben. Ein Ausfall führt nämlich zu einer Meldung beim Empfangselement. Bei passiven Systemen, z.B. einem Infrarotdetektor der eingangs genannten Art, wird ein Ausfall des Detektorelementes von der nachgeschalteten Elektronik erkannt, wenn beim Einschalten des Pulsgenerators kein entsprechendes Ausgangssignal des Detektorelementes erzeugt wird.

Ein Infrarotdetektor arbeitet im wesentlichen nach folgendem Prinzip:

Einem pyroelektrischen Detektorelement wird ein Feldeffekttransistor als Sourcefollower nachgeschaltet, um die hohe Ausgangsimpedanz des Elementes in der Größenordnung $10^{13}$ Ohm auf eine elektronische verarbeitbare Impedanz in der Größenordnung 5 k zu reduzieren. Bei einer solchen Schaltung stellt sich am Signalausgang des Feldeffekttransistors eine sogenannte Offsetspannung in der Größenordnung 1 V ein. Bei Beschädigung des Kristallempfängermaterials oder Keramikempfängermaterials, zum Beispiel durch gebrochene Drahtzuführungen, ändert sich die Offsetspannung am Ausgang nicht. Dies ist die weitaus häufigste Fehlerursache, die vorkommen kann, weil durch unsachgemäße Behandlung durch Fall oder Stoß ein Brechen der Verbindungsdrähte im Detektor leicht möglich ist. Eine Prüfung des Detektors auf Funktiontüchtigkeit ist auch dadurch möglich, daß der Benutzer des Alarmsystems einen Walk-in-Test macht, d.h., daß er im optischen Empfangsbereich des Melders sich bewegt, und somit einen gewollten Alarm auslöst. Bei Nichtauslösung des Alarms ist darauf zu schließen, daß der Detektor als Empfangselement oder die Elektronik defekt sind. Dieses Verfahren ist recht umständlich und zeitraubend und kann bei Abwesenheit des Benutzers natürlich nicht zum Tragen kommen. Auf der anderen Seite muß die Funktiontüchtigkeit der Anlage selbstverständlich gerade bei der Abwesenheit des Benutzers sichergestellt sein.

Der Erfindung liegt die Aufgabe zugrunde, einen Infrarotdetektor der eingangs genannten Art so auszubilden, daß eine laufende Kontrolle der Funktionsfähigkeit und eine sichere Alarmgabe erfolgen.

Diese Aufgabe ist erfindungsgemäß dadurch gelöst, daß zwei Detektorelemente vorhanden sind und daß jedem Detektorelement je ein Infrarotsender zugeordnet ist.

Die erfindungsgemäße Lösung ist völlig unabhängig von einer gegebenenfalls zwischen Infrarotsender und Detektorelement angeordneten Optik, Art und Einsatzgebiet des Gerätes etc. Sie erlaubt eine Kontrolle jedes Detektorelementes, das auf Wärmestrahlung reagiert. Jeder Infrarot sender, der in einem bestimmten Zeitrhythmus für eine bestimmte Zeit in der Größenordnung von einer Sekunde aktiviert wird, erzeugt ein Signal für das entsprechende Detektorelement, das dessen Überprüfung gewährleistet. Wegen der Verwendung eines Dual-Detektors mit zwei Detektorelementen ist eine sichere Alarmgabe gewährleistet.

Ein Stromimpuls von ca. 1 mA für die Dauer von 0,6 Sekunden reicht z. B. aus, um ein Signal von 2 mV am Detektorausgang zu erzeugen. Die Schaltschwellen in Infrarot-Alarmgeräten oder in Alarmgeräten allgemein liegen bei ca. 200 µV, d.h. prinzipiell würde ein Signal größer 200 µV völlig ausreichen. Die Signalform zur Ansteuereung des wärmeabstrahlenden Elementes ist nicht von Bedeutung.

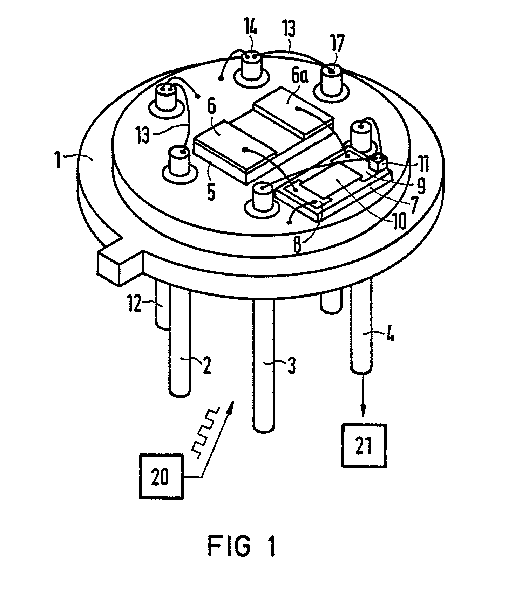

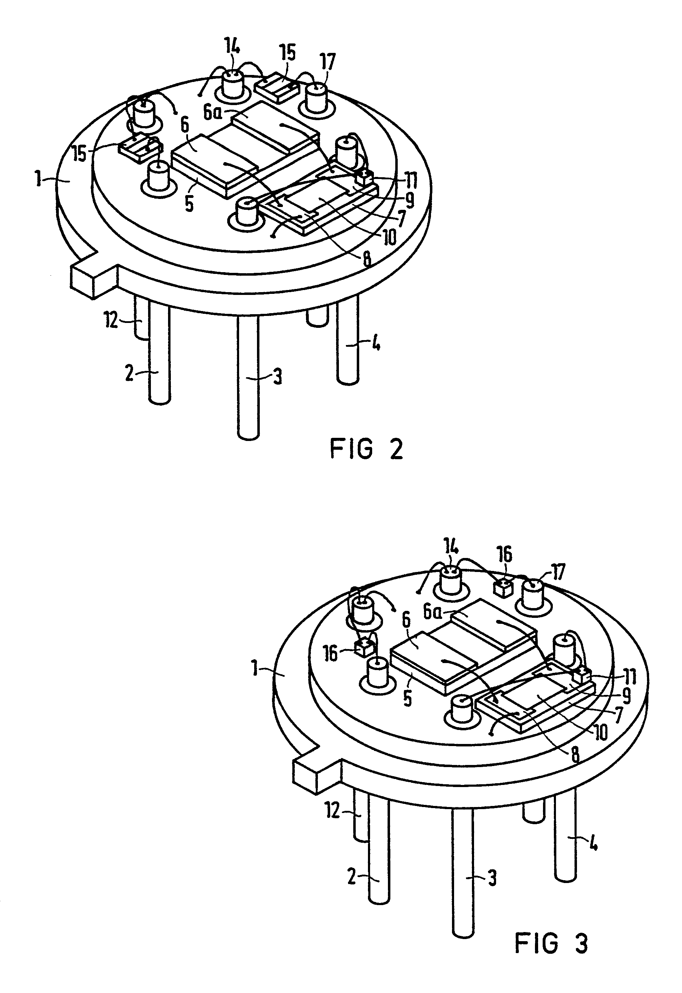

Die Erfindung ist nachfolgend anhand von drei in den Figuren 1 bis 3 dargestellten Ausführungsbeispielen näher erläutert.

In den Figuren 1 bis 3 ist ein Infrarotdetektor dargestellt, bei dem eine Grundplatte 1 vorhanden ist, von der drei Anschlußstifte 2, 3, 4 nach unten ragen. Auf der Oberseite der Grundplatte 1 sind zwei Detektorelemente 6, 6a mit Hilfe eines Kunststoffsockels 5 befestigt. Von den Detektorelementen 6, 6a führen Anschlußdrähte zu einer weiteren, auf der Grundplatte 1 befestigten Isolierstoffplatte 7, und zwar zu leitfähigen Bahnen 8, 9 auf dieser Isolierstoffplatte 7. Zwischen den leitfähigen Bahnen 8, 9 ist ein hochohmiger Widerstand 10 angeordnet. Ferner sitzt auf der leitfähigen Bahn 9 ein Feldeffekttransistor 11. Die Komponenten 6, 10, 11 sind in der dargestellten Weise verdrahtet und mit den Anschlußstiften 2, 3, 4 verbunden.

Der in den Figuren 1 bis 3 dargestellte Infrarotdetektor weist einen weiteren Anschlußstift 14 auf, der an einem Pulsgenerator 20 für die Erzeugung von Rechteckimpulsen angeschlossen ist.

Die Ausführungsbeispiele gemäß den Figuren 1 bis 3 stellen einen Dual-Detektor mit zwei infrarotempfindlichen Detektorelementen 6, 6a dar. Es sind zwei Infrarotsender vorhanden, von denen je einer je einem Detektorelement 6, 6a zugeordnet ist. Der eine Infrarotsender ist zwischen den beiden Anschlußstiften 2, 12 und der andere Infrarotsender zwischen den beiden Anschlußstiften 14, 17 angeordnet, so daß jeder der beiden Infrarotsender je ein Detektorelement 6, 6a bestrahlt.

Bei dem Beispiel gemäß Figur 1 sind die Infrarotsender von zwei Widerstandsdrähten 13, bei dem Beispiel gemäß Figur 2 von zwei Chip-Widerständen 15 und bei dem Beispiel gemäß Figur 3 von zwei Leuchtdioden 16 gebildet.

Bei allen Ausführungsbeispielen wird die Strahlung des jeweiligen Infrarotsenders 13, 15, 16 durch den Pulsgenerator 20 gepulst und das Ausgangssignal der Detektorelemente 6, 6a wird durch eine Erkennungsschaltung 21 erfaßt. Die Erkennungsschaltung 21 erkennt, ob den periodischen Pulsen des Pulsgenerators 20 entsprechende Signale erzeugt werden. Bei fehlerhaften Detektorelementen 6, 6a erkennt dies die Erkennungsschaltung 21 und es kann ein entsprechendes Signal erzeugt werden.

## Ansprüche

Infrarotdetektor mit mindestens einem infrarotempfindlichen Detektorelement (6, 6a), bei dem mindestens ein Infrarotsender (13, 15, 16) vorhanden ist, dessen Strahlung auf das Detektorelement (6, 6a) gerichtet ist und dem ein Pulsgenerator - (20) für die Pulsung der Infrarotstrahlung zugeordnet ist, und bei dem dem Detektorelement (6, 6a) eine Erkennungsschaltung (21) für das vom Infrarotsender (13, 15, 16) erzeugte Signal zugeordnet ist, **dadurch gekennzeichnet**, daß zwei Detektorelemente (6, 6a) vorhanden sind und daß jedem Detektorelement (6, 6a) je ein Infrarotsender (13, 15, 16) zugeordnet ist.

FIG 1

FIG 2

FIG 3

Europäisches
Patentamt

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | EP-A-0 066 370  (SANTA BARBARA RESEARCH CENTER) * Zusammenfassung; Seite 6, Zeile 22 - Seite 8, Zeile 15; Patentanspruch 1; Figuren 1,2 * | 1 | G 08 B  29/00 |
| | --- | | |
| Y | GB-A-2 141 228  (SHORROCK) * Seite 1, Zeilen 66-130; figuren 1,2 * | 1 | |
| | --- | | |
| A | EP-A-0 078 443  (ARMTEC) * Seite 3, Zeile 17 - Seite 5, Zeile 28; Seite 6, Zeilen 15-17; Figur 1 * | 1 | |
| | --- | | |
| A | WO-A-8 300 558  (DETECTOR ELECTRONIC CORP.) * Zusammenfassung * | 1 | RECHERCHIERTE SACHGEBIETE (Int. Cl.4) |
| | ----- | | G 08 B |

Der vorliegende Recherchenbericht wurde für alle Patentansprüche erstellt.

| Recherchenort | Abschlußdatum der Recherche | Prüfer |
|---|---|---|
| DEN HAAG | 14-01-1987 | SGURA S. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82